# EUROPÄISCHE PATENTSCHRIFT

(11) **EP 1 847 894 B1**
(45) Veröffentlichungstag und Bekanntmachung des Hinweises auf die Patenterteilung: **22.10.2008**
(21) Anmeldenummer: 06008111.4
(22) Anmeldetag: 19.04.2006
(51) Int. Cl.: G05B 19/418, H04L 12/00

(54) **Abzweigelement zum Betrieb in einem Kommunikationsnetzwerk, Netzwerk und Verfahren zum Betrieb des Abzweigelements**
Branch element for operating in a communication network, network and method for operating a branch element
Elément de dérivation destiné au fonctionnement dans un réseau de communication, réseau et procédé destinés au fonctionnement de l'élément de dérivation

(43) Veröffentlichungstag der Anmeldung: 24.10.2007
(73) Patentinhaber: SIEMENS AKTIENGESELLSCHAFT, 80333 München (DE)
(72) Erfinder: Benz, Georg, Dr., 90766 Fürth (DE); Wenzel, Waldemar, 90766 Fürth (DE)

(56) Entgegenhaltungen:
- WO-A-20/05053221
- GB-A- 2 407 237
- US-A- 5 920 266

## Beschreibung

Die Erfindung betrifft ein Abzweigelement zum Betrieb in einem Kommunikationsnetzwerk, wie insbesondere aus der WO 2005/053221 bekannt. Des Weiteren betrifft die Erfindung auch ein Netzwerk mit zumindest zwei Abzweigelementen sowie ein Verfahren zum Betrieb solcher Abzweigelemente. In der GB 2 407 237 ist ein Abschlusselement für eine Netzwerkleitung und in der US 5,920,266 ist eine Vorrichtung zur automatischen Terminierung einer Netzwerkleitung beschrieben.

Bei dem redundanten Kommunikationsnetzwerk nach der WO 2005/053221 wird ein Fehler auf einem Hauptleitungsstück durch die dort vorgesehenen Abzweigelemente isoliert. Schalter in der Hauptleitung trennen die fehlerhafte Leitung ab. Durch eine mittels eines Redundanzmanagers vorgesehene Redundanzumschaltung werden die dem Fehlerort räumlich nächstliegenden Abzweigelemente von der fehlerabgewandten Seite mit Betriebsspannung versorgt. Das fehlerhafte Hauptleitungsstück wird von beiden Seiten mittels der Abzweigelemente durch den Redundanzmanager im Wege der Einspeisung eines Prüfstroms und Auswertung von Strom und Spannung durch den Redundanzmanager geprüft. Bei einer Prüfung des Hauptleitungsstücks von beiden Seiten durch dasselbe Prinzip wird allerdings der Gutfall nicht erkannt. Zur Aufhebung einer Trennung der Hauptleitung bei einer erkannten Fehlersituation ist nach einer Reparatur bisher die manuelle Reaktivierung z. B. mittels eines Tasters und eines damit ausgelösten Umschaltimpulses vorgesehen.

Nachteilig ist insoweit, dass stets ein Benutzereingriff erforderlich ist.

Der Erfindung liegt daher die Aufgabe zugrunde, die eingangs genannten Vorrichtungen sowie ein korrespondierendes Verfahren zum Betrieb solcher Vorrichtungen zu verbessern, und zwar derart, dass ein fehlerfreier Zustand selbsttätig, also automatisch, erkannt wird.

Diese Aufgabe wird erfindungsgemäß mit einem Abzweigelement mit den Merkmalen des Anspruchs 1 gelöst. Dazu ist bei einem Abzweigelement gemäß dem Oberbegriff des Anspruchs 1 vorgesehen, dass das Abzweigelement einspeisende Prüfmittel und abschließende Prüfmittel aufweist, dass das oder jedes einspeisende Prüfmittel zur Einspeisung eines Prüfstroms auf die Linie ausgebildet ist, dass das oder jedes abschließende Prüfmittel zur Detektierung des Prüfstroms auf der Linie ausgebildet ist und dass das oder jedes abschließende Prüfmittel bei Detektion des Prüfstroms zur Deaktivierung eines dem Abzweigelement zugeordneten Busabschlusses ausgebindet ist.

Die Erfindung geht dabei von der Erkenntnis aus, dass es für die Erkennung des fehlerfreien Zustands notwendig ist, dass ein Abzweigelement einen Prüfstrom einspeist und dass ein weiteres Abzweigelement den Prüfstromabschluss abbildet. Genau dann ist nämlich ein auswertbarer Stromkreis über die zu prüfende Leitung, nämlich die Linie, geschlossen.

Der Vorteil der Erfindung besteht also schwerpunktmäßig darin, dass durch das Zusammenwirken der einspeisenden und abschließenden Prüfmittel der fehlerfreie Zustand nach Reparatur automatisch erkennbar ist, so dass das Gesamtsystem, nämlich ein Netzwerk mit mindestens zwei derartigen Abzweigelementen, eine "Selbstheilungsfähigkeit" besitzt, derart, dass der fehlerfreie Zustand nach Reparatur erkannt wird und durch Deaktivieren des Abzweigelements mit dem dem involvierten abschließenden Prüfmittel zugeordneten Busabschluss eine zuvor bewirkte Auftrennung der fehlerhaften Leitung rückgängig gemacht wird.

Die abhängigen Ansprüche sind auf bevorzugte Ausführungsformen der vorliegenden Erfindung gerichtet.

Wenn das einspeisende Prüfmittel zum Einspeisen des Prüfstroms entsprechend einem vorgegebenen oder vorgebbaren Prüfstromeinspeisungstakt und/oder das abschließende Prüfmittel zum Detektieren des Prüfstroms entsprechend einem vorgegebenen oder vorgebbaren Prüfstromdetektionstakt ausgebildet und/oder vorgesehen ist, ist es auch ohne eine Kommunikation, eine Synchronisation oder eine sonstige Wechselwirkung zwischen den beteiligten Abzweigelementen möglich, dass das Abzweigelement, in dem das einspeisende Prüfmittel aktiviert ist, während einer Zeitspanne - letztlich also während einer "Überlappung" entsprechender Zustände von Prüfstromeinspeisungstakt und Prüfstromdetektionstakt - den Prüfstrom auf die Linie einspeist, in der in einem ebenfalls involvierten Abzweigelement das dortige abschließende Prüfmittel aktiviert ist, so dass der Stromkreis, in dem der Prüfstrom auswertbar ist, über das einspeisende Prüfmittel und das abschließende Prüfmittel geschlossen ist. Mit geschlossenem Stromkreis und Detektierung des Prüfstroms ist eine Erkennung der Rückkehr des fehlerfreien Zustands möglich.

Das Vorliegen einer Zeitspanne, während derer gleichzeitig bei einem ersten Abzweigelement das einspeisende Prüfmittel und bei einem weiter involvierten Abzweigelement das abschließende Prüfmittel aktiviert ist, lässt sich garantieren, wenn der Prüfstromeinspeisungstakt unterschiedlich vom Prüfstromdetektionstakt ist. Dann sind nämlich die beiden bestimmenden Takte asynchron, so dass sich in endlicher Zeit eine Verschiebung derart einstellt, dass während dieser endlichen Zeit zumindest einmal gleichzeitig in einem Abzweigelement das einspeisende Prüfmittel und im weiter involvierten Abzweigelement das abschließende Prüfmittel aktiviert ist.

Bevorzugt ist das einspeisende Prüfmittel eine seriell in einer Stromzuführleitung der Linie anzuordnende Prüfstromquelle mit einem Prüfstromaktivierungsschalter, wobei die Prüfstromquelle und damit das Einspeisen des Prüfstroms mit dem Prüfstromaktivierungsschalter aktivierbar ist.

Weiter bevorzugt umfasst das abschließende Prüfmittel eine in Form eines Parallelabgriffs zwischen der Stromzuführleitung und einer Stromrückführleitung der Linie anzuordnende Prüfstromsenke und einen Detektierungsaktivierungsschalter, wobei die Prüfstromsenke und damit eine Möglichkeit zum Schließen eines für den Prüfstrom vorgesehenen Stromkreises, umfassend das einspeisende Prüfmittel, die Stromzuführleitung, das abschließende Prüfmittel und die Stromrückführleitung, mit der Aktivierung des Detektierungsaktivierungsschalters aktiviert wird.

Bevorzugt ist als Busabschluss ein zu- und abschaltbares RC-Glied vorgesehen.

Zum Betrieb eines Abzweigelements der oben genannten Art ist vorgesehen, dass das einspeisende Prüfmittel den Prüfstrom entsprechend dem vorgegebenen oder vorgebbaren Prüfstromeinspeisungstakt einspeist, und zwar insbesondere in die Stromzuführleitung der Linie. Weiter ist vorteilhaft zum Betrieb eines Abzweigelements vorgesehen, dass das abschließende Prüfmittel eine Präsenz des Prüfstroms auf der Linie entsprechend dem vorgegebenen oder vorgebbaren Prüfstromdetektionstakt überprüft, und zwar insbesondere indem ein Stromfluss über die Prüfstromsenke zwischen der Stromzuführleitung und der Stromrückführleitung der Linie überwacht und erkannt wird.

Nachfolgend werden Ausführungsbeispiele der Erfindung anhand der Zeichnungen näher erläutert. Einander entsprechende Gegenstände oder Elemente sind in allen Figuren mit den gleichen Bezugszeichen versehen.

Darin zeigen:
- FIG 1: eine schematisch vereinfachte Darstellung zweier durch eine Linie kommunikativ verbundener Abzweigelemente und
- FIG 2: ein Timingdiagram.

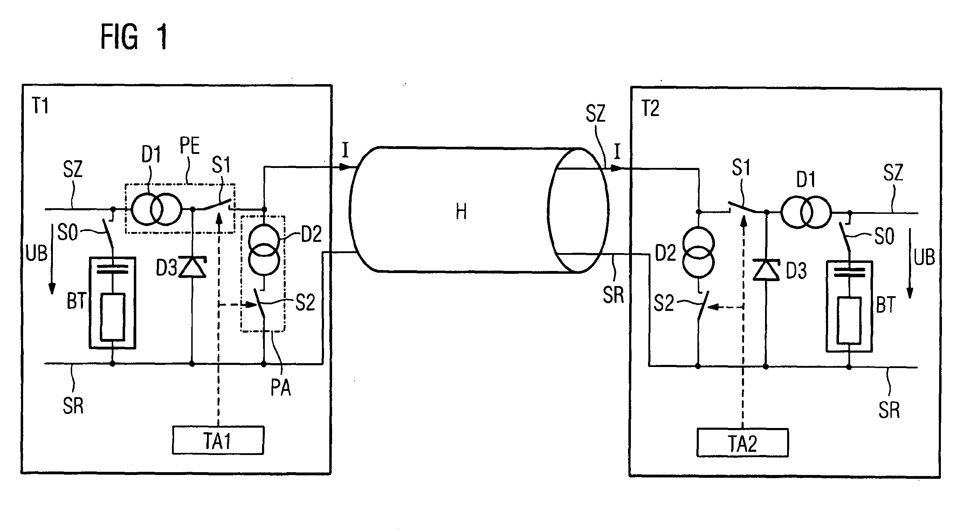

FIG 1 zeigt zwei Abzweigelemente T1, T2, wie sie in der oben in Bezug genommenen WO 2005/053221 einzeln, z. B. in FIG 4, dargestellt sind.

Zwischen den beiden Abzweigelementen T1, T2, von denen aus Gründen der Übersichtlichkeit nur zwei dargestellt sind, wobei selbstverständlich ist, dass ein Netzwerk (vergleiche WO 2005/053221; dort Bezugsziffer 11) mehr als zwei Abzweigelemente T1, T2 umfassen kann, besteht eine Kopplung in Form einer elektronisch leitenden Verbindung. Die Verbindung zwischen den beiden dargestellten Abzweigelementen T1, T2 wird im Folgenden als Linie H bezeichnet, wobei zwischen anderen, nicht dargestellten Abzweigelementen bestehende kommunikative Verbindungen ebenfalls auf Basis solcher Liniensegmente realisiert sind, so dass das Liniensegment H stellvertretend für die in der WO 2005/053221 mit H1, H2, H3, H4 und H5 bezeichneten sowie eventuelle weitere Liniensegmente steht.

Für die dargestellten Abzweigelemente T1, T2 sind nur diejenigen Details dargestellt, die im Zusammenhang mit der vorliegenden Erfindung von Interesse sind. Auf eine Darstellung weiterer Details ist aus Gründen der Übersichtlichkeit verzichtet worden, wobei das Auslassen solcher Elemente in der Darstellung selbstverständlich nicht bedeutet, dass eventuelle zusätzliche Elemente, Bauteile oder Schaltungen, z. B. wie in der WO 2005/053221 angegeben, in den dargestellten Abzweigelementen T1, T2 nicht vorhanden sein können.

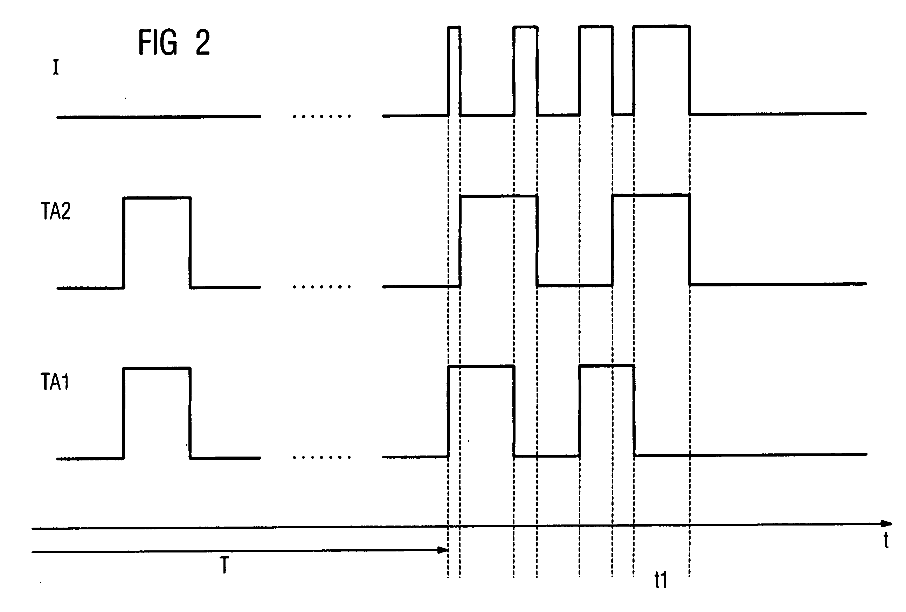

Jedes Abzweigelement T1, T2 umfasst einen Taktgenerator TA1, TA2. Darüber hinaus umfasst jedes Abzweigelement T1, T2 einspeisende Prüfmittel PE und abschließende Prüfmittel PA. Das einspeisende Prüfmittel PE umfasst eine seriell in einer Stromzuführleitung SZ der Linie H angeordnete Prüfstromquelle D1 und einen Prüfstromaktivierungsschalter S1. Das abschlieβende Prüfmittel PA umfasst eine in Form eines Parallelabgriffs zwischen der Stromzuführleitung SZ und einer Stromrückführleitung SR der Linie H angeordnete Prüfstromsenke D2 und einen Detektierungsaktivierungsschalter S2. Jeder Taktgenerator TA1, TA2 erzeugt ein in FIG 2 dargestelltes Rechtecksignal TA1', TA2' und insoweit den Prüfstromeinspeisungstakt bzw. den Prüfstromdetektionstakt. Nachdem in der in FIG 1 dargestellten Ausführungsform beide Abzweigelemente T1, T2 identisch aufgebaut sind, sind die vorgewählten Begriffe, also Prüfstromeinspeisungstakt und Prüfstromdetektionstakt, nur in dem Bemühen um eine sprachliche Trennung gewählt worden, so dass von dem auf Seiten des ersten Abzweigelements T1 generierten Rechtecksignal TA1' im Folgenden als Prüfstromeinspeisungstakt und von dem auf Seiten des zweiten Abzweigelements T2 generierten Rechtecksignal TA2' als Prüfstromdetektionstakt gesprochen wird. Tatsächlich erfolgt im Betrieb eine Prüfstromeinspeisung und Prüfstromdetektion alternierend mit Wirkung für jedes Abzweigelement T1, T2. In jedem Abzweigelement T1, T2 ist also zu einem bestimmten Zeitpunkt entweder das einspeisende Prüfmittel PE oder das abschließende Prüfmittel PA aktiviert. Die alternierende und gegenseitig ausschließende Aktivierung entweder des einspeisenden oder des abschließenden Prüfmittels PE, PA wird dadurch bewirkt, dass z. B. bei einem "high"-Pegel des Rechtecksignals TA1' des Taktgenerators TA1 des ersten Abzweigelements T1 das einspeisende Prüfmittel PE aktiviert wird, indem der diesem zugeordnete Prüfstromaktivierungsschalter S1 geschlossen wird. Gleichzeitig würde bei einem solchen Pegel des Rechtecksignals TA1' das abschließende Prüfmittel PA desselben Abzweigelements T1 deaktiviert, indem der diesem zugeordnete Detektierungsaktivierungsschalter S2 geöffnet wird. Bei einem Pegelwechsel des Rechtecksignals TA1' ergeben sich umgekehrte Verhältnisse, d. h. das abschließende Prüfmittel PA ist aktiviert und der Detektierungsaktivierungsschalter S2 geschlossen, während das einspeisende Prüfmittel PE aufgrund des geöffneten Prüfstromaktivierungsschalters S1 deaktiviert ist. Für das zweite Abschlusselement T2 ergeben sich aufgrund des dort vorgesehenen Signalgenerators TA2 und des resultierenden Rechtecksignals TA2' korrespondierende Verhältnisse hinsichtlich der Aktivierung und Deaktivierung des einspeisenden bzw. abschließenden Prüfmittels PE, PA.

Die Wirkungsweise der Erfindung wird nun anhand der weiteren Darstellung gemäß FIG 2 deutlich, in der dargestellt ist, dass z. B. während des anfänglichen "high"-Pegels des Rechtecksignals TA1' das Rechtecksignal TA2' einen "low"-Pegel hat, wobei der "high"-Pegel beim Rechtecksignal TA1' eine Aktivierung des einspeisenden Prüfmittels PE auf Seiten des ersten Abzweigelements T1 und der "low"-Pegel des zweiten Rechtecksignals TA2' eine Aktivierung des abschließenden Prüfmittels PA auf Seiten des zweiten Abzweigelements T2 bewirkt. Wie leicht anhand der Prinzipschaltung gemäß FIG 1 nachvollzogen werden kann, wird in einer solchen Konstellation ein Stromkreis für einen durch die Prüfstromquelle D1 des einspeisenden Prüfmittels PE des ersten Abzweigelements T1 auf die Linie H, nämlich die Stromzuführleitung SZ, gegebener Prüfstrom I über das abschließende Prüfmittel PA, insbesondere die Stromsenke D2 des zweiten Abzweigelements T2 und die Stromrückführleitung SR geschlossen, so dass tatsächlich ein Prüfstrom I fließt, wie in dem Diagram gemäß FIG 2 in dem oberen Graph für den Prüfstrom I dargestellt. Während eines Zeitraums, während dessen beide Rechtecksignale TA1', TA2' einen "high"-Pegel aufweisen und entsprechend bei beiden Abzweigelementen T1, T2 die dortigen einspeisenden Prüfmittel PE aktiviert sind, ergibt sich kein geschlossener Stromkreis, so dass kein Prüfstrom I fließt, wie dies entsprechend auch im Graph für den Prüfstrom I in FIG 2 angegeben ist. Erst wenn sich der Pegel beider Rechtecksignale TA1', TA2' wieder unterscheidet, im dargestellten Fall also beim Wechsel des Pegels des Rechtecksignals TA1' vom "high"-Pegel zum "low"-Pegel, ergibt sich wieder ein Stromfluss, wobei in dieser Konstellation aufgrund des "low"-Pegels im Rechtecksignal TA1' auf Seiten des ersten Abzweigelements T1 das dortige abschließende Prüfmittel PA aktiviert ist und aufgrund des "high"-Pegels im zweiten Rechtecksignal TA2' auf Seiten des zweiten Abzweigelements T2 das dortige einspeisende Prüfmittel PE aktiviert ist. Es ergibt sich also im Vergleich zu der vorherigen Konstellation, bei der sich mit den beteiligten einspeisenden bzw. abschließenden Prüfmitteln PE, PA ein Stromkreis für den Prüfstrom I ergeben hat, jetzt die quasi umgekehrte oder spiegelbildliche Situation, indem der Stromkreis für den Prüfstrom I über das einspeisende Prüfmittel PE des zweiten Abzweigelements T2, die Stromzuführleitung SZ, das abschließende Prüfmittel PA des ersten Abzweigelements T1 und die Stromrückführleitung SR der Linie H geschlossen ist. In beiden Fällen fließt jedoch ein Prüfstrom I, wie aus dem diesbezüglichen Graph in FIG 2 ersichtlich ist, so dass der fehlerfreie Zustand der Linie H, also jeder beliebigen Verbindung zwischen zweier benachbarter Abzweigelemente T1, T2 mit zumindest einer Stromzuführleitung SZ und einer Stromrückführleitung SR erkennbar ist.

Weiter ist in FIG 2 erkennbar, dass die beiden Rechtecksignale TA1' TA2' asynchron zueinander sind, wobei sich eine solche Asynchronität bevorzugt ohne zusätzlichen schaltungstechnischen Aufwand und dergleichen aufgrund einer endlichen Güte, also insbesondere Temperatureinflüssen und Bauteilparameterschwankungen der involvierten elektrischen oder elektronischen Bauteile und aufgrund variierender Anfangszustände ergibt. Damit lässt sich in ausreichendem Maße sicherstellen, dass nach einer Zeit T unterschiedliche Taktzustände an den Abzweigelementen T1, T2 vorherrschen.

Durch die aus Prüfstromquelle D1 und zugeordneter Zenerdiode D3 gebildete Konstantstromquelle ist der getaktete Prüfstrom I vom eigentlichen Nutzsignal, dem so genannten PA-Signal, entkoppelt. Durch den Prüfstrom I ergibt sich also keine Störung des Nutzsignals.

Sobald der Prüfstrom I erkannt wird, wird eine als Busabschluss BT vorgesehene Schaltung, insbesondere ein als RC-Glied ausgeführter Abschlusswiderstand des jeweiligen Abzweigelements T1, T2, weggeschaltet. Zu diesem Zweck ist ein dem Busabschluss BT zugeordneter Busabschlussschalter S0 vorgesehen. Eine aus dem Prüfstrom I und/oder dem Wegschalten des Busabschlusses BT resultierende Signalüberhöhung wird vom Redundanzmanager (siehe WO 2005/053221; dort Bezugszeichen RM) erkannt. Dieser kann dann den fehlerfreien Zustand aktivieren. Fehlerfreiheit der Linie H kann sicher dann erkannt werden, wenn der Prüfstrom I mindestens für eine vorgegebene und vorgebbare Zeitspanne t1 (vergleiche FIG 2) ansteht. Je nach Modulation des Nutzsignals, also insbesondere des PA-Signals, wobei bei diesem von einer Modulation mit 30 kHz auszugehen ist, ergibt sich ein unterer Schwellwert für die Zeit t1. Bei einer Modulation mit 30 kHz beträgt der untere Schwellwert für die Zeit t1 z. B. dreißig Mikrosekunden. Während dieser Zeit muss der Prüfstrom I anstehen, damit die Signalüberhöhung des Nutzsignals sicher auftritt.

Bis zur automatischen Erkennung des "Gutzustands" vergeht die Zeit T. Für die Zeit T steht ein eventueller Fehler länger an. Ein neuer, weiterer Fehler ist in diesem Betriebszustand t < T als zweiter Fehler zu sehen. Die Zeit T wird klein gewählt und ist zu minimieren, indem eine hohe Asynchronität zwischen den Rechtecksignalen TA1', TA2' angestrebt wird, was insbesondere mit Bauteilen mit hohen Toleranzen erreichbar ist.

## Patentansprüche

1. Abzweigelement zum Betrieb in einem Kommunikationsnetzwerk (11), insbesondere PROFIBUS PA-Netzwerk, mit Redundanzeigenschaften, wobei die Topologie des Netzwerks (11) eine Linie (H) aufweist und die beiden Linienenden an einen Redundanzmanager angeschlossen sind, der dazu ausgebildet ist, im Fehlerfall die beiden Linienenden miteinander zu verbinden,
**dadurch gekennzeichnet,**
**dass** das Abzweigelement (T1, T2) einspeisende Prüfmittel (PE) und abschließende Prüfmittel (PA) aufweist,
**dass** das oder jedes einspeisende Prüfmittel (PE) zur Einspeisung eines Prüfstroms auf die Linie (H) ausgebildet ist, dass das oder jedes abschließende Prüfmittel (PA) zur Detektion des Prüfstroms auf der Linie (H) ausgebildet ist und dass das oder jedes abschließende Prüfmittel (PA) bei Detektion des Prüfstroms zur Deaktivierung eines dem Abzweigelement zugeordneten Busabschlusses (BT) ausgebildet ist.

2. Abzweigelement nach Anspruch 1,
wobei das einspeisende Prüfmittel (PE) zum Einspeisen des Prüfstroms entsprechend einem vorgegebenen oder vorgebbaren Prüfstromeinspeisungstakt ausgebildet ist.

3. Abzweigelement nach Anspruch 1 oder 2,
wobei das abschließende Prüfmittel (PA) zum Detektieren des Prüfstroms entsprechend einem vorgegebenen oder vorgebbaren Prüfstromdetektionstakt ausgebildet ist.

4. Abzweigelement nach Anspruch 2 und 3,
wobei der Prüfstromeinspeisungstakt unterschiedlich vom Prüfstromdetektionstakt ist.

5. Abzweigelement nach einem der vorangehenden Ansprüche,
wobei das einspeisende Prüfmittel (PE) eine seriell in einer Stromzuführleitung (SZ) der Linie (H) anzuordnende Prüfstromquelle (D1) und einen Prüfstromaktivierungsschalter (S1) umfasst.

6. Abzweigelement nach einem der vorangehenden Ansprüche,
wobei das abschließende Prüfmittel (PA) eine in Form eines Parallelabgriffs zwischen einer Stromzuführleitung (SZ) und einer Stromrückführleitung (SR) der Linie (H) anzuordnende Prüfstromsenke (D2) und einen Detektierungsaktivierungsschalter (S2) umfasst.

7. Abzweigelement nach einem der vorangehenden Ansprüche mit einem zu- und abschaltbaren RC-Glied als Busabschluss (BT).

8. Netzwerk mit mindestens zwei Abzweigelementen nach einem oder mehreren der vorangehenden Ansprüche.

9. Verfahren zum Betrieb eines Abzweigelements nach einem der Ansprüche 2, 4, 5, 6 oder 7,
wobei das einspeisende Prüfmittel (PE) den Prüfstrom entsprechend einem vorgegebenen oder vorgebbaren Prüfstromeinspeisungstakt einspeist, insbesondere in die Stromzuführleitung (SZ) der Linie (H).

10. Verfahren nach Anspruch 9,
wobei das abschließende Prüfmittel (PA) eine Präsenz des Prüfstroms auf der Linie (H) entsprechend einem vorgegebenen oder vorgebbaren Prüfstromdetektionstakt überprüft, insbesondere einen Stromfluss über die Prüfstromsenke (D2) zwischen der Stromzuführleitung (SZ) und der Stromrückführleitung (SR) der Linie (H).

## Claims

1. Branch element for operation in a communication network (11), in particular a PROFIBUS PA network, with redundancy characteristics, whereby the topology of the network (11) has a line (H) and the two line ends are connected to a redundancy manager, which is designed to connect the two line ends to each other in the event of a fault,
**characterized in that**,
the branch element (T1, T2) has supplying test equipment (PE) and terminating test equipment (PA),
the or each supplying test equipment (PE) is designed to supply a test current to the line (H),
the or each terminating test equipment (PA) is designed to detect the test current on the line (H) and
the or each terminating test equipment (PA) is designed to deactivate a bus termination (BT) assigned to the branch element when the test current is detected.

2. Branch element according to claim 1,
wherein the supplying test equipment (PE) is designed to supply the test current in accordance with a predetermined or predeterminable test current supply clock.

3. Branch element according to claim 1 or 2,
wherein the terminating test equipment (PA) is designed to detect the test current in accordance with a predetermined or predeterminable test current detection clock.

4. Branch element according to claim 2 and 3,
wherein the test current supply clock is different from the test current detection clock.

5. Branch element according to one of the previous claims,
wherein the supplying test equipment (PE) comprises a test current source (D1) to be arranged in series in a power supply cable (SZ) of the line (H) and a test current activator switch (S1) .

6. Branch element according to one of the previous claims,
wherein the terminating test equipment (PA) comprises a test current drain (D2) in the form of a parallel tap to be arranged between a power supply cable (SZ) and a current return cable (SR) of the line (H) and a detection activator switch (S2).

7. Branch element according to one of the previous claims with an RC module that can be switched on or off as bus termination (BT).

8. Network with at least two branch elements according to one or several of the previous claims.

9. Method for operating a branch element according to one of claims 2, 4, 5, 6 or 7,
wherein the supplying test equipment (PE) supplies the test current according to a predetermined or predeterminable test current supply clock, in particular into the power supply cable (SZ) of the line (H).

10. Method according to claim 9,
wherein the terminating test equipment (PA) checks a presence of the test current on the line (H) according to a predetermined or predeterminable test current detection clock, in particular a current flow via the test current drain (D2) between the power supply cable (SZ) and the current return cable (SR) of the line (H).

## Revendications

1. Élément de dérivation destiné au fonctionnement dans un réseau de communication ( 11 ), notamment dans un réseau PROFIBUS-PA avec propriétés de redondance, la topologie du réseau ( 11 ) comportant une ligne ( H ) et les deux extrémités de ligne étant raccordées à un gestionnaire de redondance qui est conçu pour relier l'une à l'autre les deux extrémités de ligne en cas de défaut,
**caractérisé par le fait que**
- l'élément de dérivation ( T1, T2 ) comporte des moyens de contrôle d'introduction ( PE ) et des moyens de contrôle de terminaison ( PA ),
- le ou chaque moyen de contrôle d'introduction ( PE ) est conçu pour l'introduction d'un courant de contrôle sur la ligne ( H ) ,
- le ou chaque moyen de contrôle de terminaison ( PA ) est conçu pour la détection du courant de contrôle sur la ligne ( H ), et
- le ou chaque moyen de contrôle de terminaison ( PA ) pour la détection du courant de contrôle est conçu pour la désactivation d'une terminaison de bus ( BT ) associée à l'élément de dérivation.

2. Élément de dérivation selon la revendication 1, tel que le moyen de contrôle d'introduction ( PE ) est conçu pour l'introduction du courant de contrôle en fonction d'une horloge d'introduction de courant de contrôle prédéterminée ou pouvant être prédéterminée.

3. Élément de dérivation selon la revendication 1 ou 2, tel que le moyen de contrôle de terminaison ( PA ) est conçu pour la détection du courant de contrôle en fonction d'une horloge de détection de courant de contrôle prédéterminée ou pouvant être prédéterminée.

4. Élément de dérivation selon les revendications 2 et 3, tel que l'horloge d'introduction de courant de contrôle est différente de l'horloge de détection de courant de contrôle.

5. Élément de dérivation selon l'une des revendications précédentes, tel que le moyen de contrôle d'introduction ( PE ) comprend une source de courant de contrôle ( D1 ) à agencer en série dans une ligne d'amenée de courant ( SZ ) de la ligne ( H ) ainsi qu'un interrupteur d'activation de courant de contrôle ( S1 ) .

6. Élément de dérivation selon l'une des revendications précédentes, tel que le moyen de contrôle de terminaison ( PA ) comprend un collecteur de courant de contrôle ( D2 ) à agencer sous la forme d'une prise parallèle entre une ligne d'amenée de courant ( SZ ) et une ligne de retour de courant ( SR ) de la ligne ( H ) ainsi qu'un interrupteur de désactivation de courant de contrôle ( S2 ).

7. Élément de dérivation selon l'une des revendications précédentes avec un circuit RC pouvant être branché et débranché comme terminaison de bus ( BT ).

8. Réseau avec au moins deux éléments de dérivation selon l'une ou plusieurs des revendications précédentes.

9. Procédé destiné au fonctionnement d'un élément de dérivation selon l'une des revendications 2, 4, 5, 6 ou 7, tel que le moyen de contrôle d'introduction ( PE ) introduit le courant de contrôle en fonction d'une horloge d'introduction de courant de contrôle prédéterminée ou pouvant être prédéterminée, notamment dans la ligne d'amenée de courant ( SZ ) de la ligne ( H ).

10. Procédé selon la revendication 9, tel que le moyen de contrôle de terminaison ( PA ) vérifie une présence du courant de contrôle sur la ligne ( H ) en fonction d'une horloge de détection de courant de contrôle prédéterminée ou pouvant être prédéterminée, notamment un flux de courant dans le collecteur de courant de contrôle ( D2 ) entre la ligne d'amenée de courant ( SZ ) et la ligne de retour de courant ( SR ) de la ligne ( H ).
